# EUROPEAN PATENT SPECIFICATION

(11) **EP 0 299 087 B1**
(45) Date of publication and mention of the grant of the patent: **06.04.1994**
(21) Application number: 88901309.0
(22) Date of filing: 29.01.1988
(51) Int. Cl.: H01L 21/90, H01L 23/52

(54) **SEMICONDUCTOR DEVICE AND METHOD OF FABRICATING THE SAME**
HALBLEITERANORDNUNG UND VERFAHREN ZUR HERSTELLUNG
DISPOSITIF A SEMI-CONDUCTEURS ET PROCEDE DE PRODUCTION

(30) Priority: 30.01.1987 JP 12445/87 U; 25.09.1987 JP 241932/87
(43) Date of publication of application: 18.01.1989
(73) Proprietor: SONY CORPORATION, Tokyo 141 (JP)
(72) Inventor: HAYASHI, Hisao, Shinagawa-ku Tokyo 141 (JP); MATSUSHITA, Takeshi, Shinagawa-ku Tokyo 141 (JP)
(74) Representative: TER MEER STEINMEISTER & PARTNER GbR
(86) International application number: PCT/JP88/00078
(87) International publication number: WO 88/05961

(56) References cited:
- DE-A- 2 752 344
- JP-A- 5 688 354
- JP-U-55 179 053

## Description

The present invention relates to a semiconductor device having at least one active region which is embedded between wiring structures. The invention further relates to a method of fabricating such a device.

DE-A-27 52 344 describes a method for manufacturing a MISFET. In this method, an epitaxial layer is grown on a preliminary silicon substrat, at least one active region is manufactured within said epitaxial layer, and then a wiring structure, an oxide layer and a thick layer of polycrystalline silicon are formed above said epitaxial layer. This thick polycrystalline silicon layer serves as a new substrate in a second sequence of manufacturing steps in which at first the preliminary substrate and a part of the epitaxial layer are removed except a thin semiconducting layer which comprises said at least one active region. A second wiring structure is formed above said semiconducting layer.

It is the object of the present invention to provide another semiconductor device having at least one active region embedded between two wiring structures, and it is a further object to provide a method for fabricating such a semiconductor device.

The semiconductor device according to claim 1 distinguishes from the above discussed prior art device in that it comprises a further oxide layer atop said polycrystalline silicon layer, and that a silicon substrate is bonded onto said further oxide layer.

The method according to claim 2 differs from the above discussed prior art method mainly in that in the first sequence of manufacturing steps, in which the preliminary substrate is used as supporting body, no active region is already formed, but only the first wiring layer, and that an oxide layer is deposited onto the flattened polycrystalline silicon layer, and a silicon substrate is bonded onto said oxide layer. Only in the second sequence of steps, using said bonded silicon substrate as supporting body, at least one active region is formed, and the second wiring structure is formed.

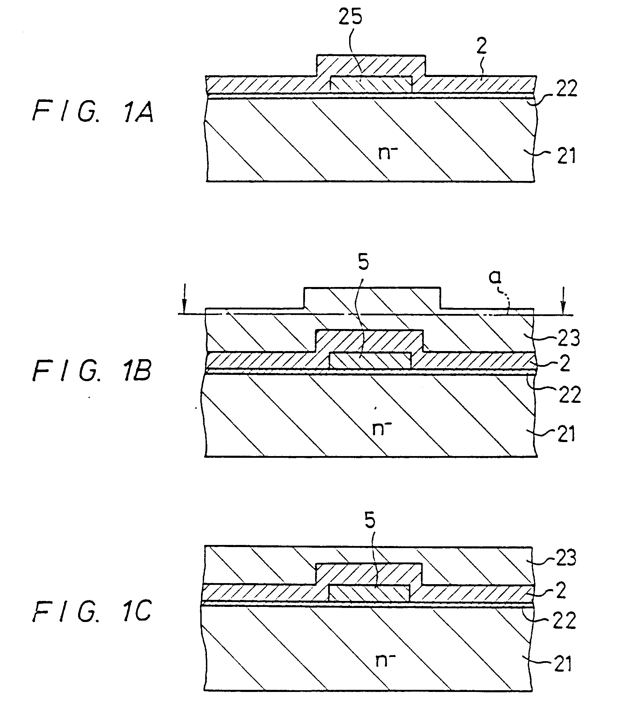

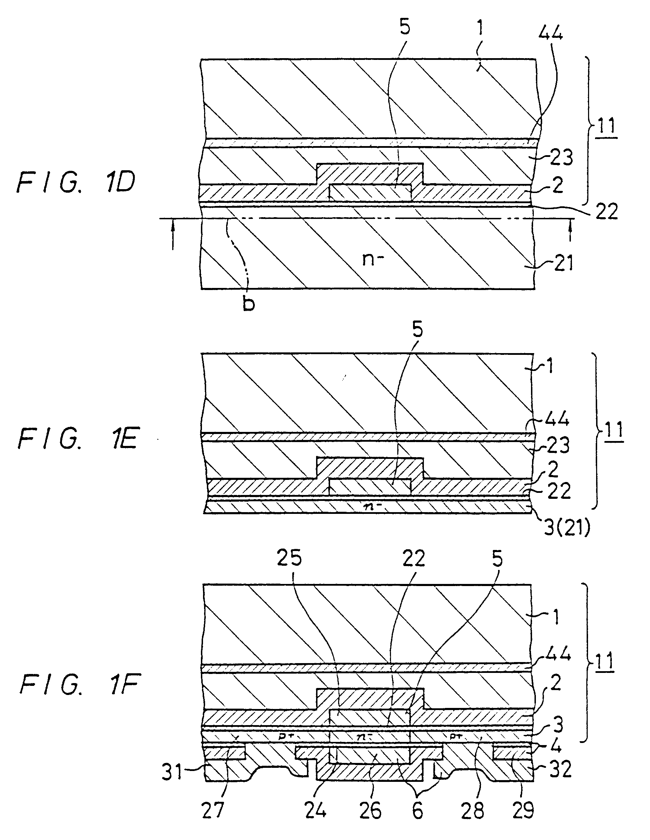

The present invention will be more clearly understood by reading the following description of a specific embodiment in conjunction with Fig. 1.

Figs. 1A to 1F are schematic cross sections through a semiconducting arrangement for different steps for manufacturing a semiconductor device as it is finally shown in the cross section of Fig. 1F.

A method for obtaining a double-side gate type MIS semiconductor device which can improve the effective carrier mobility will be described with reference to Fig. 1. In this case, as shown in Fig. 1A, a single crystal silicon semiconductor substrate 21 of, for example, n⁻ type is provided. A gate insulating film 22 is formed on its one major surface by means of a surface thermal oxidation treatment or the like, on which a first gate electrode 25, i.e., a first wiring layer 5 formed of a polycrystalline silicon layer having low resistivity is formed with a predetermined pattern, for example, with a predetermined wiring pattern covering the first gate electrode 25. The first wiring layer 5, i.e., the first gate electrode 25 in the illustrated example is formed by depositing a polycrystalline silicon layer on the entire surface by, for example, chemical vapor deposition method (CVD method) or the like and patterning the same by means of a photolithography or the like.

As shown in Fig. 1B, an intermediate layer 23 made of, for example, a polycrystalline silicon or the like of relatively large thickness is deposited on an insulating layer 2 by means of the CVD method or the like.

Then, as shown in Fig. 1C, the intermediate layer 23 is etched flat from its surface side to the position shown by a chain line a in Fig. 1B by techniques such as, for example, mechanical grading, mechanical and chemical polishing or the like.

As shown in Fig. 1D, an insulating layer 44 made of, for example, an SiO₂ or the like is formed on the flat surface of the intermediate layer 23 by a surface thermal oxidation process or the like. On this insulating layer, a single crystal or polycrystalline silicon substrate 1 is bonded. Then, the semiconductor substrate 21 is supported on a supporting member 11 which includes this substrate 1.

As shown in Fig. 1E, the semiconductor substrate 21 is etched flat from the opposite side of the supporting member 11 to the position shown by a chain line b in Fig. 1D by means of mechanical grading, mechanical and chemical polishing or etching and other well-known techniques, thus forming a semiconductor layer 3 having a sufficiently thin film thickness.

Then, as shown in Fig. 1F, the surface of the semiconductor layer 3 opposite to the surface facing the supporting member 11 is treated by, for example, a thermal oxidation process thereby to deposit a second gate insulating film 24 on that surface. On the second gate insulating film 24, there is formed a second gate electrode 26 made of a polycrystalline silicon layer of low resistivity which is formed as at least a part of a second wiring layer 6 at its position opposing the first gate electrode 25 by, for example, a method similar to that of forming the afore-mentioned first gate electrode 25. Thereafter, using this second gate electrode 26 as a mask for ion implantation, a p-type impurity of conductivity type different from that of the semiconductor layer 3 is injected into the semiconductor layer, thus forming a source region 27 and a drain region 28 of low resistivity. While in this case the source region 27 and the drain region 28 are formed with the employment of the gate electrode 26 as a mask, the first gate electrode 25 in Fig. 1A may be used as a mask to form the source region 27 and the drain region 28. Next, an insulating layer 29 of SiO₂ or the like is formed on the entire surface to protect the surface and electrode windows are bored therethrough at positions of, for example, the respective source region 27 and drain region 28 and a source electrode 31 and a drain electrode 32, for example, are deposited on these regions 27 and 28 in ohmic-contact.

These electrodes 31 and 32 can be formed simultaneously by the photolithography technique after Aℓ is vapor-deposited on the front surface. These electrodes constitute a part of the second wiring layer 6.

Thus, the double-side gate-type MIS semiconductor device can be obtained, in which the first wiring layer 5 including the first gate electrode 25 is formed on one surface of the semiconductor layer 3 and the second wiring layer 6 including the second gate electrode 26, the source electrode 31, the drain electrode 32 or the like is formed on the other surface of the semiconductor layer.

## Claims

1. A semiconductor device having
- a wiring structure (25; 26, 31, 32) on both major surfaces of a semiconductor layer (3) in which at least one active region (27, 28) has been formed;
- an oxide layer (2) on one of said wiring layers; and
- a polycrystalline silicon layer (23) on said oxide layer, the top surface of said polycrystalline silicon layer being flat;
**characterized by**
- a further oxide layer (44) on said polycrystalline silicon layer; and
- a silicon substrate (1) bonded onto said further oxide layer.

2. A method for manufacturing the semiconductor device of claim 1, said method comprising the following steps:
- depositing a first wiring structure (25, 22) on a preliminary silicon substrate (21);
- depositing an oxide layer (2) on said first wiring structure;
- depositing a polycrystalline silicon layer (23) on said oxide layer;
- flattening the top surface of said polycrystalline silicon layer;
- depositing a further oxide layer (44) on said flattened polycrystalline silicon layer;
- bonding a silicon substrate (1) onto said oxide layer;
- removing said preliminary silicon substrate except a remaining semiconducting layer (3);
- forming at least one active semiconducting region (27, 28) within said semiconducting layer; and
- forming a second wiring structure (26, 31, 32) atop said semiconducting layer.

## Patentansprüche

1. Halbleiteranordnung mit
- einer Verdrahtungsstruktur (25; 26, 31, 32) auf den beiden Hauptflächen einer Halbleiterschicht (3), in der mindestens ein aktiver Bereich (27, 28) ausgebildet wurde;
- einer Oxidschicht (2) auf einer der Verdrahtungsschichten; und
- einer polykristallinen Siliziumschicht (23) auf der Oxidschicht, wobei die Oberfläche der polykristallinen Siliziumschicht flach ist;
**gekennzeichnet durch**
- eine weitere Oxidschicht (44) auf der polykristallinen Siliziumschicht; und
- ein Siliziumsubstrat (1), das mit der weiteren Oxidschicht verbunden ist.

2. Verfahren zum Herstellen der Halbleiteranordnung nach Anspruch 1, welches Verfahren die folgenden Schritte aufweist:
- Abscheiden einer ersten Verdrahtungsstruktur (25, 22) auf einem vorläufigen Halbleitersubstrat (21);
- Abscheiden einer Oxidschicht (2) auf der ersten Verdrahtungsstruktur;
- Abscheiden einer polykristallinen Siliziumschicht (23) auf der Oxidschicht;
- Einebnen der Oberfläche der polykristallinen Siliziumschicht;
- Abscheiden einer weiteren Oxidschicht (44) auf der eingeebneten polykristallinen Siliziumschicht;
- Verbinden eines Siliziumsubstrats (1) mit der Oberfläche der Oxidschicht;
- Entfernen des vorläufigen Siliziumsubstrats mit Ausnahme einer verbleibenden halbleitenden Schicht (3);
- Ausbilden mindestens eines aktiven halbleitenden Bereichs (27, 28) innerhalb der halbleitenden Schicht; und
- Ausbilden einer zweiten Verdrahtungsstruktur (26, 31, 32) über der halbleitenden Schicht.

## Revendications

1. Dispositif semi-conducteur comportant :
une structure de câblage (25 ; 26, 31, 32) sur les deux faces principales d'une couche semi-conductrice (3) dans laquelle au moins une région active (27, 28) a été formée ;
une couche d'oxyde (2) sur l'une desdites couches de câblage ; et,
une couche de silicium polycristallin (23) sur ladite couche d'oxyde, la surface supérieure de ladite couche de silicium polycristallin étant plate ;
caractérisé par :
une couche d'oxyde supplémentaire (44) sur ladite couche de silicium polycristallin ; et,
un substrat de silicium (1) appliqué sur ladite couche d'oxyde supplémentaire.

2. Procédé de fabrication du dispositif à semi-conducteurs de la revendication 1, ledit procédé comprenant les étapes suivantes :
dépôt d'une première structure de câblage (25, 22) sur un substrat de silicium préliminaire (21) ;
dépôt d'une couche d'oxyde (2) sur ladite première structure de câblage ;
dépôt d'une couche de silicium polycristallin (23) sur ladite couche d'oxyde ;
aplanissement de la surface supérieure de ladite couche de silicium polycristallin ;
dépôt d'une couche d'oxyde supplémentaire (44) sur ladite couche de silicium polycristallin aplanie ;
application d'un substrat de silicium (1) sur ladite couche d'oxyde ;
élimination dudit substrat de silicium préliminaire, excepté une couche semi-conductrice restante (3) ;
formation d'au moins une région semi-conductrice active (27, 28) à l'intérieur de ladite couche semi-conductrice ; et,
formation d'une seconde structure de câblage (26, 31, 32) par-dessus ladite couche semi-conductrice.
